# EUROPEAN PATENT APPLICATION

(11) **EP 1 253 431 A2**
(43) Date of publication of application: **30.10.2002**
(21) Application number: 02076450.2
(22) Date of filing: 15.04.2002
(51) Int. Cl.: G01R 31/3181

(54) **A method of fault isolation of a digital electronic device**

(30) Priority: 25.04.2001 US 842526
(71) Applicant: EASTMAN KODAK COMPANY, Rochester, New York 14650 (US)
(72) Inventor: Petruccelli, Gregory D., c/o Eastman Kodak Company, Rochester, New York 14650-2201 (US); Hadgis, George A., c/o Eastman Kodak Company, Rochester, New York 14650-2201 (US); Link, Bruce A., c/o Eastman Kodak Company, Rochester, New York 14650-2201 (US)
(74) Representative: Parent, Yves

(57) **Abstract**

A method of fault isolation comprises the steps of attaching a probe to at least one pin of each sub-circuit (32-38) of the digital electronic device (10). A predefined stimulus (20) is sent to the digital electronic device and a transmission from 0 to 1 is counted for each of the probes to obtain a first sum. A transition from 1 to 0 is counted for each of the probes to obtain a second sum. The first and second sum are then compared to a predetermined criteria and a subset of the sub-circuits, which fail to meet the predetermined criteria, is determined. From the subset a sub-circuit is identified, which failed to meet the predetermined criteria and which is closest in signal progression to the predefined stimulus (20).

## Description

This invention relates in general to a method of isolating faults in a digital electronic device and in particular to determining which sub-circuit of a digital signal processing system should be further investigated or replaced to repair a fault condition.

Identifying which electronic components have failed and need to be replaced in a multi-bit digital signal processing system is difficult. The difficulty increases with the number of bits, the operating frequency of the circuits, the complexity of the circuits, and the reduction in the physical size of the components.

Conventional methods for identifying which electronic components have failed usually requires using one or more of the following:
(a) Custom In-circuit Test Equipment (i.e., "Bed of Nails"), Logic Analyzer with bus wide probing and analysis, bus wide signature analysis or custom diagnostic hardware and/or software. These methods can have the disadvantages of attaching test probes to the entire width of the data path, which is especially difficult with 32 bit data busses and wider.
(b) testing the electronic circuits at frequencies lower than the operating frequency, which can result in not detecting speed related failures.
(c) adding hardware components to the circuitry, which causes an increase in cost and reduction in the reliability of the circuit board.
The net result is an increase in cost or a reduction in the probability of detecting failures or both.

Briefly, according to one aspect of the present invention a method of fault isolation comprises the steps of attaching a probe to a pin of each sub-circuit of the digital electronic device. A predefined stimulus is sent to the digital electronic device, the logic transitions from each probe is compared to a predetermined criteria (bit transition count or bit pattern) and a subset of the sub-circuits which fail to meet the predetermined criteria is determined. From the subset a target sub-circuit is identified, which failed to meet the predetermined criteria and which is closest in signal progression to the predefined stimulus. The identified sub-circuit and the preceding sub-circuit, in signal progression, are identified for further investigation or replacement to repair the failure.

The uniqueness of the concept is not only the use of a Monitoring Bit, (i.e., bit used to assess performance) to provide failure information about the sub-circuit it is directly connected to, but to use the Monitoring Bit to "Look Through" the sub-circuit it is directly attached to and provide additional failure information about the previous stage. This ability to Look Through one stage to analyze the previous stages performance is possible if the Monitoring Bit is a function of the previous stages output bits. The amount of additional failure information acquired from measuring the transitions of the Monitoring Bit with this Look Through concept will vary with several factors unique to the application. The factors include; the number of output bits the Monitoring Bit function uses from the preceding sub-circuit, the logic function that causes the Monitoring Bit to transition, and the input stimulus used to test the circuitry.

The information acquired from the Monitoring Bits along the digital signal processing path must be interpreted to provide trouble shooting information and identify which sub-circuits of a digital signal processing system should be further investigated or replaced.

Through the use of this method, most of the costly and unreliable testing techniques usually associated with fault isolation in digital processing systems with multi-bit digital signal processing paths are avoided:
(a) sub-circuits are identified for further investigation or replacement by measuring the transitions of one bit rather than all the data bits along the image path. This reduction in the number of bits allows printed circuit boards to include more cost-effective test features and also allows the use of simplified test methods, i.e., pulse counting or single bit signature analysis.
(b) this testing method allows for testing the electronic circuitry at the designed operating frequency of the system rather than at a lower test frequency, increasing the probability of detecting speed-related failures.
(c) the method does not affect the reliability of the circuit board if the test points are added to the circuit boards only when testing is needed.

The net result is a reduction in cost and an increase in the probability of detecting failures.

The invention and its objects and advantages will become more apparent in the detailed description of the preferred embodiment presented below.
Figure 1 is a schematic diagram of a fault isolation process for a digital electronic device according to the present invention using Monitoring Bit 0 and Monitoring Bit 1.
Figure 2 is a schematic flow diagram of a fault isolation process for a digital electronic device independent of bit position.
Figure 3 is a schematic flow diagram of a fault isolation process for a digital electronic device along a multi-sub-circuital digital signal processing path using Monitoring Bits.
Figure 4 is a schematic flow diagram of a fault isolation process for a digital electronic device along a multi-sub-circuital digital signal processing path using Monitoring Bits.
Figure 5 shows a input stimulus using a transition pattern.

The present invention provides a unique means for providing trouble-shooting information to help identify which electronic components have failed in a multi-bit digital signal processing system 10.

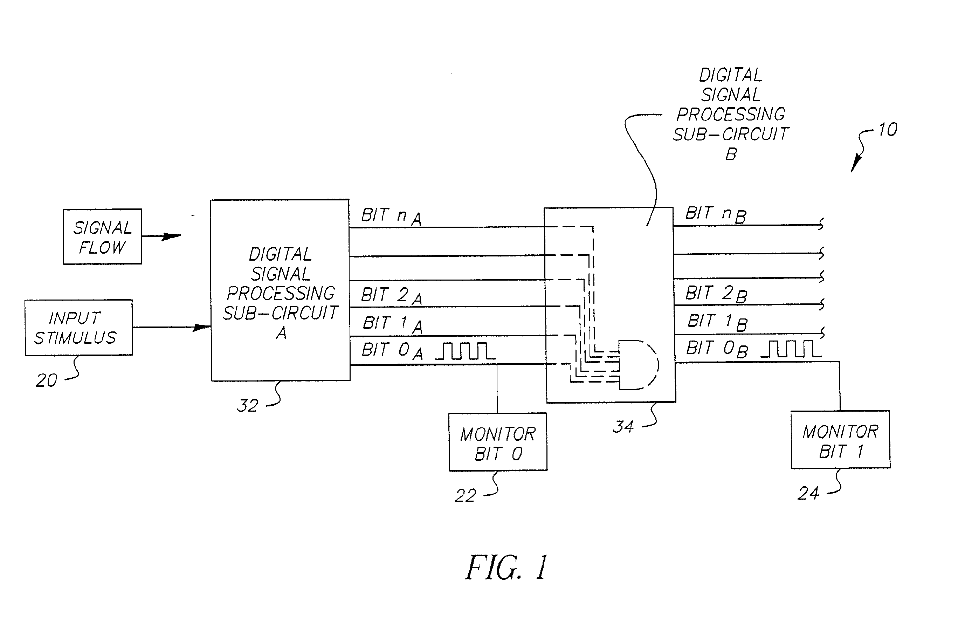

Referring to Figure 1, a predefined input stimulus 20 is input into sub-circuit 32, the number or pattern of Monitoring Bit 0 (22) and Monitoring Bit 1 (24) transitions are measured and compared to the expected number or pattern of transitions. If the number or pattern of transitions for Monitoring Bit 0 (22) or Monitoring Bit 1 (24) does not match the predefined criteria, sub-circuit 32 and sub-circuit 34 are identified as needing further investigation or replacement.

Monitoring Bit 0 (22) is a direct fault assessment of Digital Signal Processing sub-circuit 32 with an approximate coverage of one divided by the width of the signal processing bus. Monitoring Bit 1 (24) is a direct fault assessment of Digital Signal Processing sub-circuit 34 with an approximate coverage of one divided by the width of the signal processing bus. Monitoring Bit 1 (24), also and more significantly, "Looks Through" Digital Signal Processing sub-circuit 34 to provide fault information about sub-circuit 32. The additional Look Through failure detection capability from Monitoring Bit 1 (24) is possible because the transitions of Monitoring Bit 1 (24) are a function of several or all of the output bits from sub-circuit 32. Therefore, failure information for sub-circuit 32 can be obtained by comparing the measured transitions of Monitoring Bit 1 (24) to a predefined criteria.

The amount of additional fault coverage for sub-circuit 32, obtained by measuring the transitions of Monitoring Bit 1, will vary with the number of sub-circuit 32 output bits used by the Monitoring Bit 1 function, the logic function of Monitoring Bit 1 and the input stimulus used to test sub-circuit 32.

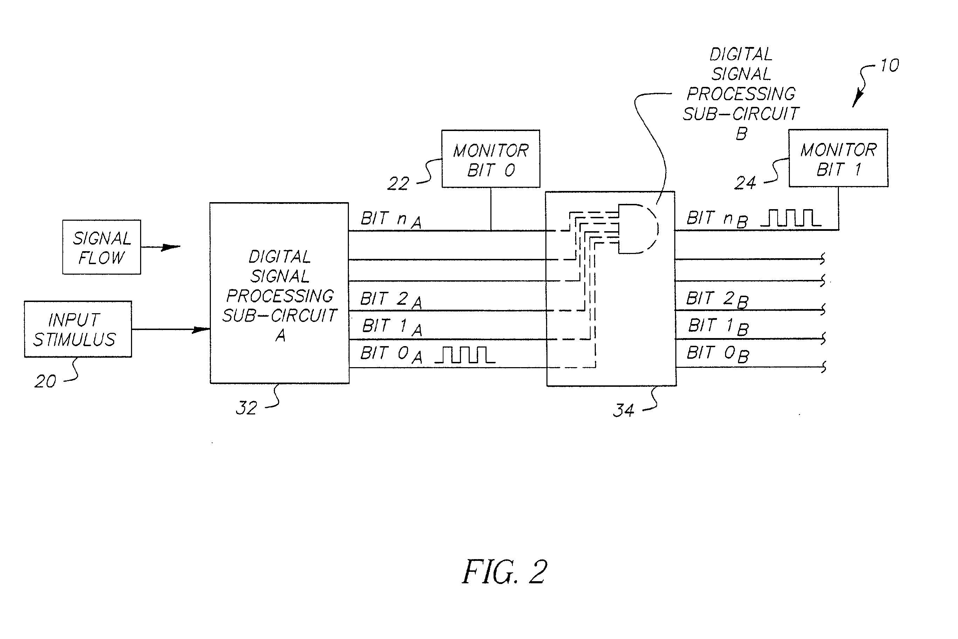

Figure 2 illustrates that any bit in the data bus of a digital signal processing sub-circuit can be used as a Monitoring Bit to test and identify sub-circuits for further investigation or replacement. Monitoring Bit 0 (22) is a direct fault assessment of Digital Signal Processing sub-circuit 32 with an approximate coverage of one divided by the width of the signal processing bus. Monitoring Bit 1 (24) is a direct fault assessment of Digital Signal Processing sub-circuit 34 with an approximate coverage of one divided by the width of the signal processing bus. Monitoring Bit 1 (24) also provides additional failure for sub-circuit 32 by "Looking Through" Digital Signal Processing sub-circuit 34 to provide fault information about sub-circuit 32. The amount of fault coverage for sub-circuit 32 obtained by measuring the transitions of Monitoring Bit 1 (24) will vary with the number of sub-circuit 32 output bits used by the Monitoring Bit (24) function, the logic function of Monitoring Bit 1 (24) and the input stimulus used to test sub-circuit 32.

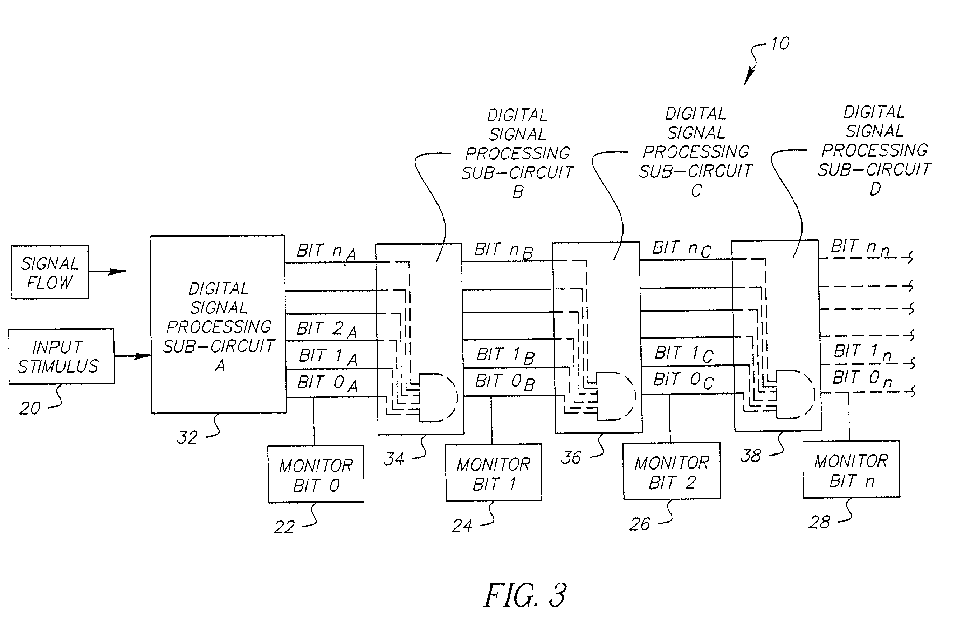

Figure 3 illustrates the ability to expand this method of testing digital signal processing sub-circuits using one bit Monitoring to provide sub-circuit fault isolation information for digital signal processing systems. The method inputs a known stimulus 20 into the beginning of the digital signal processing path (i.e., sub-circuit 32), the number or pattern of transitions for each of the Monitoring Bits 22-28 along the digital signal processing path are measured and compared to their individual criteria. If the comparison of the Monitoring Bits to their individual criteria yields a difference; the system identifies the sub-circuit closest in signal progression to the input stimulus 20 that failed to meet its criteria, the target sub-circuit, and the preceding sub-circuit in signal progression for further investigation or replacement. The Monitoring Bits provide fault assessment data for Digital Signal Processing sub-circuits 32-38, which they are directly connected to with an approximate coverage of one divided by the width of the signal processing bus. The Monitoring Bits 22-28 also provide a Look Through failure detection capability for preceding the sub-circuits. The additional Look Through failure detection capability from the Monitoring Bits is possible because the transitions of the Monitoring Bit are a function of several or all of the output bits from the preceding sub-circuit. The amount of fault coverage information obtained from Monitoring Bit with the Look Through concept will vary with the number of output bits used from the preceding sub-circuit, the logic function of the Monitoring Bit and the input stimulus 20.

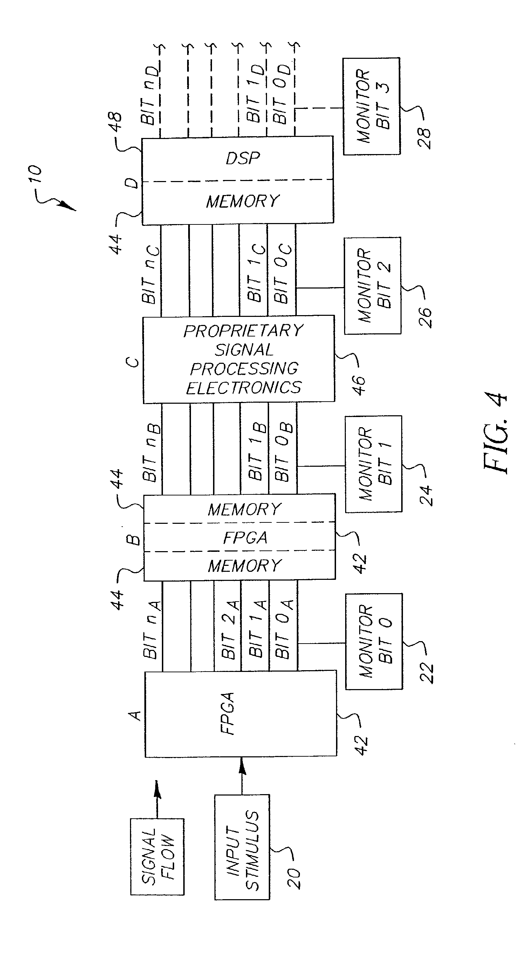

Figure 4 illustrates how actual electronic components may be configured to work with this method. This method is not in anyway limited to the components shown or the configuration shown. The method can aid in identifying failed sub-circuits in digital signal processing systems using many different types of electronic components, such as FPGA 42, DSP 48, ASIC, microprocessors 46, and memory 44.

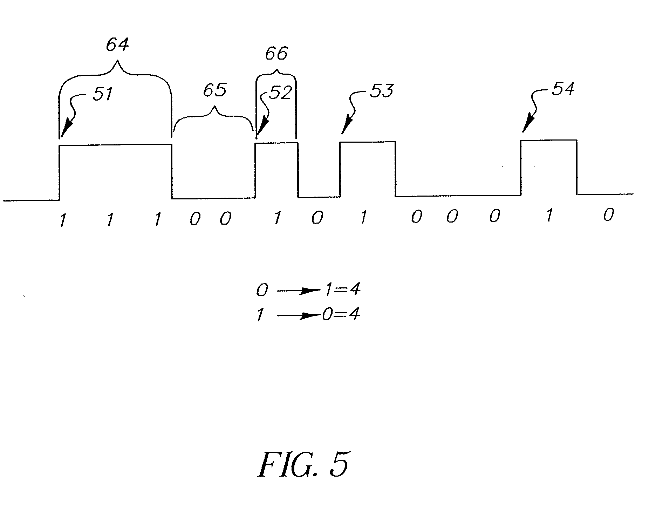

A transition pattern is shown in Figure 5. A pattern can be defined as simply counting a number of transitions (1 to 0 and/or 0 to 1) without concern for the amount of time the Monitoring Bit remains at 1 or 0. A pattern could also be defined as simply a counted number of transitions (1 to 0 and/or 0 to 1) with reference to the amount of time the Monitoring Bit remains at 1 or 0. For example, in Figure 5 if counting transitions, four transitions 51-54 are shown from 0 to 1. However, looking for patterns, Figure 5 shows a pattern with 64 being three time units wide, 65 being two time units wide, and 66 being one time units wide. Therefore, patterns may be used to determine performance of the digital electronic device.

## Claims

1. A method of fault isolation for a digital electronic device comprising the steps of:
attaching a probe to a pin of each sub-circuit of said digital electronic device;
sending a predefined stimulus to said digital electronic device;
counting transitions from 0 to 1 for said probe to obtain a first sum for each of said sub-circuits;
counting transition from 1 to 0 for said probe to obtain a second sum for each of said sub-circuits;
comparing said first sums and second sums to a predetermined criteria for each of said sub-circuits;
determining a subset of said sub-circuits which fail to meet said predetermined criteria for said first sums and said second sums; and
identifying a target sub-circuit from said subset which fails to meet said predetermined criteria and which is closest in signal progression to said predefined stimulus.

2. A method as in claim 1 wherein additional testing of said target sub-circuit and any sub-circuits between said target sub-circuit and said predefined stimulus is performed.

3. A method of fault isolation for a digital electronic device comprising the steps of:
attaching a probe to one pin of a first sub-circuit of said digital electronic device;
sending a predefined stimulus to said digital electronic device;
counting transitions from 0 to 1 for said probe to obtain a first sum for said probe;
counting transitions from 1 to 0 for said probe to obtain a second sum for said probe;
comparing said first sum and second sum to a predetermined criteria;
determining whether said first sub-circuit failed to meet said predetermined criteria for said first sum and said second sums; and
moving said probe to a pin of a second sub-circuit closest in signal progression to said predefined stimulus if said first sub-circuit fails to meet said predetermined criteria.

4. A method of fault isolation for a digital electronic device comprising:
attaching a plurality of probes to a plurality of sub-circuits of said digital electronic device;
wherein one probe is attached to one individual pin of each for said sub-circuits;
sending a predefined stimulus to said digital electronic device;
counting a transition from 0 to 1 for each of said probes to obtain a first sum for each of said probes;
counting a transition from 1 to 0 for each of said probes to obtain a second sum for each of said probes;
comparing each of said first sums and each of said second sums to a predetermined criteria;
determining a subset of said sub-circuits which fail to meet said predetermined criteria for each of said first sums and said second sums; and
identifying a target sub-circuit from said subset which fails to meet said predetermined criteria and which is closest in signal progression to said predefined stimulus.

5. A method as in claim 4 wherein additional testing of said target sub-circuit and any sub-circuits between said target sub-circuit and said predefined stimulus is performed.

6. A method of fault isolation for a digital electronic device comprising the steps of:
attaching a probe to a pin of each sub-circuit of said digital electronic device;
sending a predefined stimulus to said digital electronic device;
determining a transition pattern for said probes;
comparing said transition pattern to a predetermined criteria;
determining a subset of said sub-circuits which fail to meet said predetermined criteria; and
identifying a target sub-circuit from said subset which fails to meet said predetermined criteria and which is closest in signal progression to said predefined stimulus.

7. A method as in claim 6 wherein additional testing of said target sub-circuit and any sub-circuits between said target sub-circuit and said predefined stimulus is performed.
